# EUROPEAN PATENT APPLICATION

(11) **EP 1 517 369 A2**
(43) Date of publication of application: **23.03.2005**
(21) Application number: 04255574.8
(22) Date of filing: 15.09.2004
(51) Int. Cl.: H01L 23/31, H01L 23/485

(54) **Method of manufacturing wafer level chip size package**

(30) Priority: 18.09.2003 JP 2003325938
(71) Applicant: Minami Co. Ltd., Fuchu-shi, Tokyo (JP)
(72) Inventor: Murakami, Takehiko c/o Minami Co. Ltd., Fuchu-shi, Tokyo (JP)
(74) Representative: Neill, Alastair William

(57) **Abstract**

To widely improve an entire manufacturing efficiency by efficiently forming a thermal stress relaxing post, an insulating layer and a solder bump, arewiringcircuit (3) is formedonawafer (1) byplating, a thermal stress relaxing post (4) made of a conductive material such as a solder or the like is formed on the rewiring circuit (3), an insulating layer (6) made of a polyimide or the like is formed in the periphery of the rewiring circuit (3) and the thermal stress relaxing post (4) except a top surface of the thermal stress relaxing post (4), a solder bump (7) is formed on the thermal stress relaxing post (4), and the thermal stress relaxing post (4), the insulating layer (6) and the solder bump (7) are formed by screen printing.

## Description

### BACKGROUND OF THE INVENTION

### FIELD OF THE INVENTION

The present invention relates to a method of manufacturing a wafer level chip size package.

### DESCRIPTON OF THE PRIOR ART

On the basis of a demand for high density mounting in a cellular phone, a digital video, a digital camera and the like, the chip size package (CSP) corresponding to a compact package is going to become rapidly popular.

In the CSP, since a mounting area is smaller and a wiring length is shorter in comparison with a conventional lead type package such as a thin small outline package (TSOP) and a quad flat package (QFP), there is a characteristic that the CSP is easily applied to a high-frequency device. Further, in comparison with a flip chip in which a chip is directly mounted on a substrate, since it is possible to widen a pad pitch, there is a characteristic that it is easy to mount on the substrate. In other words, the CSP is becoming rapidly popular because it is possible to achieve a high-speed and high-density mounting on a level of the flip chip with hardiness easiness in handling on a level of the TSOP.

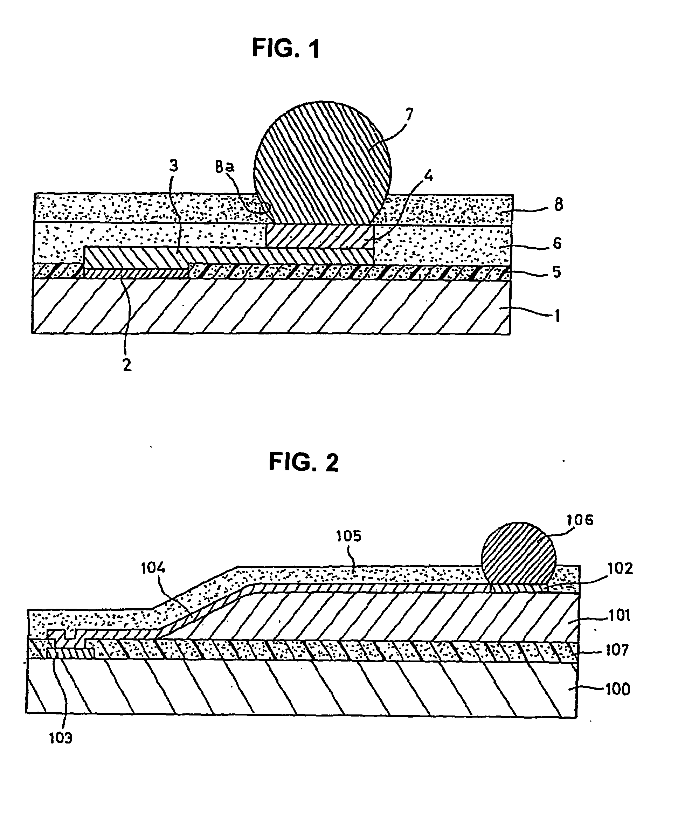

Accordingly, a conventional method of manufacturing the wafer level CSP is as shown in Fig. 2, and is constituted by a step of forming a desired thickness of thermal stress relaxing layer 101 made of an insulating material on a wafer 100, a step of forming a land 102 and a rewiring circuit 104 connecting the land 102 to a bonding pad 103 on a top surface of the thermal stress relaxing layer 101, forming an insulating layer 105 on the rewiring circuit 104, and a step of thereafter forming a solder bump 106 on the 1 and 102. In this case, the thermal stress relaxing layer 101 lowers a thermal strain of the solder bump generated due to a difference in coefficients of linear expansion of the wafer and the printed circuit board at a time of mounting the wafer on the printed circuit board, thereby improving a connection service life. The thermal stress relaxing layer 101 is mainly made of a resin having an elasticity, deforms in correspondence to the strain of the solder bump 106, and reduces the strain on the basis of the deformation. In addition, reference numeral 107 is a insulating layer formed on the wafer 100.

Further, in the conventional structure, the thermal stress relaxing layer 101 is formed in accordance with a printing process, the rewiring circuit 104 is formed in accordance with a plating process, the insulating layer 105 is formed in accordance with an applying process, and the solder bump 106 is formed by reprinting a solder ball on the land 102 and heating by a reflow furnace. However, there is a problem that too much labor hour and time are required for forming the insulating layer 105 and the solder bump 106, and an operation efficiency is deteriorated. Further, in the conventional structure, since the thermal stress relaxing layer 101 is made of the insulating material, it is necessary to form the land 102 in a center of a top surface thereof, so that there is a problem that an excess time is required for forming.

### SUMMARY OF THE INVENTION

The present invention is made by taking the points mentioned above into consideration, and an object of the present invention is to provide a method of manufacturing a wafer level chip size package (CSP) which can widely improve an operation efficiency.

Therefore, in accordance with a main aspect of the present invention, there is provided a method of manufacturing a wafer level chip size package (CSP) comprising the steps of:
forming a rewiring circuit on a wafer in accordance with a plating process, and forming a thermal stress relaxing post made of a conductive material such as a solder or the like on the rewiring circuit;
forming an insulating layer made of a polyimide or the like in the periphery of the rewiring circuit and the thermal stress relaxing post except a top surface of the thermal stress relaxing post; and
forming a solder bump on the thermal stress relaxing post,
wherein the thermal stress relaxing post, the insulating layer and the solder bump are formed in accordance with a screen printing process.

Further, in the manufacturing method mentioned above, it is preferable that a solder is used as the conductive material for forming the thermal stress relaxing post. In this case, the connection between the solder corresponding to the material for the thermal stress relaxing post and the solder bump is constituted by a fusion on the basis of an inter-metallic compound, and is stronger than a fusion on the basis of a counter-diffusion between the solder corresponding to the material of the thermal stress relaxing post and the rewiring circuit in accordance with the plating process.

Further, in the manufacturing method mentioned above, the structure may be made such that a thermal stress support layer made of an insulating material and provided with a receiving portion for an outer periphery of a lower portion of the solder bump at a position of the thermal stress relaxing post is formed on a top surface of the insulating layer in accordance with a screen printing process. Accordingly, it is possible to further lower a thermal strain of the solder bump.

A best mode for carrying out the present invention is to form the thermal stress relaxing post, the insulating layer and the solder bump in accordance with the screen printing process.

### BRIEF DESCRIPTION OF THE DRAWINGS

Fig. 1 is a cross sectional view of a wafer level chip size package (CSP) manufactured in accordance with the present invention; and
Fig. 2 is a cross sectional view of a wafer level CSP manufactured in accordance with a conventional method.

### DESCRIPTION OF PREFERRED EMBODIMENT

A description will be given below of an embodiment in accordance with the present invention with reference to the accompanying drawing.

Fig. 1 is a view showing a cross section of a wafer level chip size package (CSP) manufactured in accordance with the present invention.

In the drawing, reference numeral 1 denotes a wafer. Reference numeral 2 denotes a bonding pad formed on the wafer 1. The bonding pad 2 is a gold UBM. Reference numeral 3 denotes a rewiring circuit formed on the wafer 1 in accordance with a plating process. Reference numeral 4 denotes a thermal stress relaxing post formed on the rewiring circuit 3 and made of a conductive material such as a solder or the like. The thermal stress relaxing post 4 is formed in accordance with a screen printing process by a pressure type screen printing machine. In this case, a solder is used as the conductive material.

Reference numeral 5 denotes an insulating layer formed on the wafer 1, and reference numeral 6 denotes an insulating layer formed in the periphery of the rewiring circuit 3 and the thermal stress relaxing post 4 except a top surface of the thermal stress relaxing post 4 and made of a polyimide or the like. Further, the insulating layer 6 is formed in accordance with the screen printing process by the pressure type screen printing machine.

Reference numeral 7 denotes a solder bump formed on the thermal stress relaxing post 4. The solder bump 7 is formed in accordance with the screen printing process by the pressure type screen printing machine. Reference numeral 8 denotes a thermal stress support layer formed on a top surface of the insulating layer 6 and provided with a receiving portion 8a for an outer periphery of a lower portion of the solder bump 7 at a position of the thermal stress relaxing post 4. Further, the thermal stress support layer 8 is made of an insulating material such as a polyimide or the like, and is formed in accordance with the screen printing process.

In accordance with the present invention, since the thermal stress relaxing post, the insulating layer and the solder bump are formed as mentioned above in accordance with the screen printing process, it is possible to widely improve the operation efficiency in comparison with the conventional manufacturing method. Further, since the solder bump is formed directly on the thermal stress relaxing post, it is not necessary to form the land as in the conventional method. Therefore, it is possible to reduce the working process for forming the land.

Further, in the case that the solder is used as the conductive material for forming the thermal stress relaxing post, the connection with the solder bump is constituted by the fusion on the basis of the inter-metallic compound, and thus a firm connection is achieved.

Further, in the case that the thermal stress support layer constituted by the insulating material provided with the receiving portion for the outer periphery of the lower portion of the solder bump at the position of the thermal stress relaxing post is formed on the top surface of the insulating layer in accordance with the screen printing process, it is possible to further lower the thermal strain of the solder bump.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A method of manufacturing a wafer level chip size package (CSP) comprising the steps of:
forming a rewiring circuit on a wafer in accordance with a plating process, and forming a thermal stress relaxing post made of a conductive material such as a solder or the like on said rewiring circuit;
forming an insulating layer made of a polyimide or the like in the periphery of the rewiring circuit and the thermal stress relaxing post except a top surface of said thermal stress relaxing post; and
forming a solder bump on said thermal stress relaxing post,
wherein said thermal stress relaxing post, the insulating layer and the solder bump are formed in accordance with a screen printing process.

2. A method of manufacturing a wafer level CSP as claimed in claim 1, wherein a solder is used as the conductive material for forming the thermal stress relaxing post.

3. A method of manufacturing a wafer level CSP as claimed in claim 1, wherein a thermal stress support layer made of an insulating material and provided with a receiving portion for an outer periphery of a lower portion of the solder bump at a position of the thermal stress relaxing post is formed on a top surface of the insulating layer in accordance with a screen printing process.

4. A method of manufacturing a wafer level CSP as claimed in claim 2, wherein a thermal stress support layer made of an insulating material and provided with a receiving portion for an outer periphery of a lower portion of the solder bump at a position of the thermal stress relaxing post is formed on a top surface of the insulating layer in accordance with a screen printing process.
